# EUROPEAN PATENT APPLICATION

(11) **EP 4 664 755 A1**
(43) Date of publication of application: **17.12.2025**
(21) Application number: 24305925.0
(22) Date of filing: 12.06.2024
(51) Int. Cl.: H03F 1/22, H03F 1/56, H03F 3/195

(54) **MULTIPLE COIL LOW NOISE AMPLIFIER WITH TRANSIMPEDANCE FOR HIGH FREQUENCY RADIO**

(71) Applicant: NXP USA, Inc., Austin TX 78735 (US)
(72) Inventor: EL KASSIR, Bilal, 31023 Toulouse Cedex 1 (FR)
(74) Representative: Schmütz, Christian Klaus Johannes

(57) **Abstract**

A multiple coil low noise amplifier with transimpedance is described for high frequency radio. In an example, an amplifier includes a first coil electrically coupled to an input node of an amplifier, configured to provide an input to the input node, a second coil inductively coupled to the first coil and electrically coupled to a ground node of the amplifier, configured to ground the amplifier, a third coil electrically coupled to an output node of the amplifier and to ground, configured to filter an amplifier output at the node, and a fourth coil inductively coupled to the third coil and electrically coupled to the output node, configured to provide the amplifier output.

## Description

### BACKGROUND

Electronics devices frequently use low noise amplifiers embedded in an integrated circuit (IC). The low noise amplifier may be for radio reception, e.g., Wi-Fi, Wi-Int, or cellular networks, or for audio speakers, or video displays. An embedded low noise amplifier is designed and laid out in a particular semiconductor library for a particular manufacturing process to be included within an integrated circuit (IC) that may be produced at high volume and low cost. Low noise amplifiers for wireless connectivity are adapted to the frequency bands available to the transmitter for radio frequency (RF) communication. For the millimeter wave domain, e.g., V and W bands, a wide bandwidth, e.g., 8 GHz, is allocated. For these purposes, amplifiers are made of several stages to use gain compensation, which is sensitive to the quality of embedded capacitors and the intrinsic characteristics of each of the components of each stage.

A four-stage Low Noise Amplifier (LNA) may have 5 transformers resonating with a bank of capacitors to generate sufficient gain throughout the allocated bandwidth. Such a resonator requires high precision in the capacitors, which is difficult to obtain in integrated circuits.

### SUMMARY

Embodiments of a method and apparatus for a multiple coil lower noise amplifier with transimpedance for high frequency radio is described. In an example, an amplifier includes a first coil electrically coupled to an input node of an amplifier, configured to provide an input to the input node, a second coil inductively coupled to the first coil and electrically coupled to a ground node of the amplifier, configured to ground the amplifier, a third coil electrically coupled to an output node of the amplifier and to ground, configured to filter an amplifier output at the node, and a fourth coil inductively coupled to the third coil and electrically coupled to the output node, configured to provide the amplifier output.

In some examples, the amplifier is a cascode.

In some examples, the ground node is coupled to a gate of a common base of the cascode and to a source of a common emitter of the cascode.

Some examples include a resistance between the input node of the cascode and a drain of a common base of the cascode.

In some examples, the resistance comprises a resistor capacitor combination.

In some examples, the first coil, the second coil, the third coil, and the fourth coil are formed as conductive layers on a substrate of an integrated circuit.

In some examples, the first coil and the second coil are formed on different layers on the substrate.

In some examples, the third coil is in a first layer having a first connection pad, wherein the fourth coil is a second layer having a second connection pad, wherein the first connection pad is electrically coupled to the second connection pad, and the fourth coil is inductively coupled to the third coil.

In some examples, the first coil and the second coil are configured as a first feedback transformer for a voltage-to-voltage transformer to the input node.

In some examples, the third coil and the fourth coil are configured as a second feedback transformer for a current-to-current transformer to the output node.

In some examples, the first coil and the fourth coil are shunt coils.

In some examples, the second coil is a degeneration coil.

In some examples, the third coil is a choke coil.

In some examples, the choke coil further comprises a fifth coil coupled in series with the third coil, wherein the fifth coil is coupled to an output of the amplifier on one side and to the third coil on the other side, wherein the third coil is coupled to the fifth coil on one side and to the ground on the other side, and wherein the fourth coil is coupled to the junction of the third coil and the fifth coil.

In another example, a method includes receiving an input analog signal at a first feedback transformer, converting the input analog signal to a first voltage at the first feedback transformer, applying the first voltage as an input to a cascode amplifier, receiving a second voltage as an output from the cascode amplifier, converting the second voltage to a current at a second feedback transformer; and providing the second voltage as a current output to an amplifier through an output coil.

In some examples, converting the input analog signal comprises applying the input analog signal to a first feedback transformer, the first feedback transformer having an input coil electrically coupled to the input analog signal and a degeneration coil inductively coupled to the input coil and electrically coupled to a ground node of the cascode amplifier.

In some examples, converting the second voltage comprises applying the second voltage to a second feedback transformer, the second feedback transformer having an output coil electrically connected to the second voltage and a choke coil inductively coupled to the output coil.

In another example an apparatus includes an antenna port configured to receive a radio frequency signal from an antenna, an output port configured to provide an amplified signal to a load, and a low noise amplifier configured to receive the radio frequency signal at the antenna port and to provide the amplified signal to the output port, the low noise amplifier having a first coil electrically coupled to an input node of an amplifier, configured to provide an input to the input node, a second coil inductively coupled to the first coil and electrically coupled to a ground node of the amplifier, configured to ground the amplifier, a third coil electrically coupled to an output node of the amplifier and to ground, configured to filter an amplifier output at the node, and a fourth coil inductively coupled to the third coil and electrically coupled to the output node, configured to provide the amplifier output.

In some examples, the low noise amplifier further comprises a second stage between the fourth coil and the amplifier output, the second stage having an input node, a ground node, and an output node coupled to the amplifier output.

In some examples, the second stage has an input coil coupled to the fourth coil.

Other aspects in accordance with the invention will become apparent from the following detailed description, taken in conjunction with the accompanying drawings, illustrated by way of example of the principles of the invention.

### BRIEF DESCRIPTION OF THE DRAWINGS

Fig. 1 is a simplified block diagram of an amplifier system in accordance with an embodiment of the invention.
Fig. 2 is a diagram of an amplifier with five inductors in accordance with an embodiment of the invention.
Fig. 3 is a diagram of an alternative amplifier with five inductors in accordance with an embodiment of the invention.
Fig. 5 is a diagram of an isometric view diagram of three different layers for coils of a transformer section in accordance with an embodiment of the invention.
Fig. 6 is a diagram of an isometric view diagram of the coils of Fig. 5 formed over each other for use as a transformer section in accordance with an embodiment of the invention.
Fig. 7 is a diagram of a two-stage differential amplifier in accordance with an embodiment of the invention.
Fig. 8 is a process flow diagram of operating an amplifier system in accordance with an embodiment of the invention.

Throughout the description, similar reference numbers may be used to identify similar elements.

### DETAILED DESCRIPTION

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

The described low noise amplifier provides a wide band of operational frequencies using transimpedance stages. The transimpedance stages have passive inductive components that are magnetically coupled one with the other. By the design of the layout of the inductors in both size and overlap, the coupling factors between each of the inductors may be determined as additive or subtractive. With inductors providing the feedback within the amplifier, the amplifier gain spread is small and does not depend on the precision of the capacitors. With embedded integrated circuit capacitors, the characteristics of the capacitors are affected by variations in the production process. Large resonator capacitors require a large area in the integrated circuit and high precision. The transimpedance design may be used to reduce the surface area and the power consumption of the amplifier yet with sufficient gain.

A two stage Low Noise Amplifier (LNA) is described with five inductors magnetically coupled together to reduce the area required on the substrate, increase the operational bandwidth, and be more robust against production process spread. In examples, the power consumption of the LNA is reduced by a factor of three compared to resonant capacitor designs. No capacitors are required for the transimpedance stages eliminating the difficulty of precision resonant capacitors.

The transimpedance design with five inductors is configured to provide a mixing between "voltage to voltage," "voltage to current," "current to voltage," and "current to current" feedback. The design provides very wide bandwidth and small gain tilt in the band.

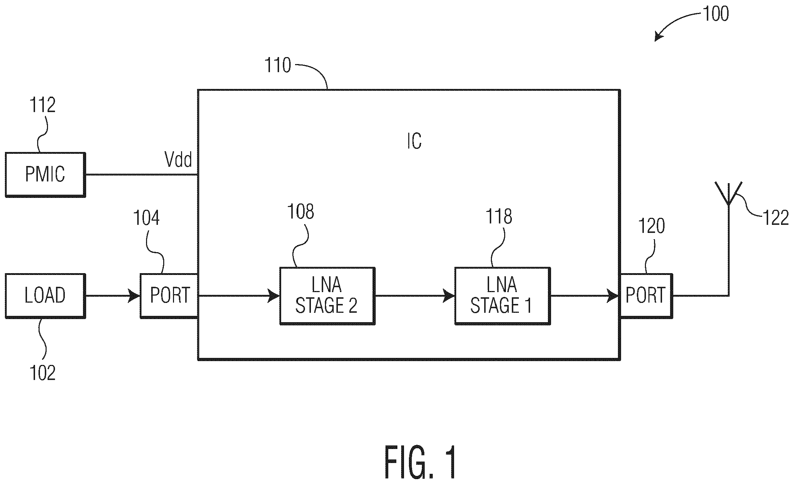

Fig. 1 is a simplified block diagram of an amplifier system. The amplifier system is shown as a portion of a receiver chain. A load 102 receives an analog signal from an LNA 110 though an output port 104. The load 102 may be a digital signal processor (DSP), receiver or any other suitable load for an amplified analog signal. The analog signal may be in the form of symbols, points, tones, waveforms, or another type of signal for radio frequency transmission from an antenna.

An antenna 122 receives a radio frequency (RF) signal and is coupled to an input port 120, e.g., an antenna port, of the LNA 110 to provide an input analog signal to the LNA 110. There may be other components between the antenna 122 and the input port 120, e.g., combiners, demultiplexers, downconverters, filters, couplers, delays, etc. The LNA 110 is shown as having a first stage 118 and a second stage 108, however there may be more or fewer stages. The first stage 118 is coupled to the second stage 108 to amplify the input analog signal from the antenna 122 at the input port 120 and provide the amplified signal to the output port 104. The first stage 118 and the second stage 108 may include laterally-diffused metal-oxide semiconductor (LDMOS) amplifiers, cascode amplifiers, and other circuitry to provide gain and impedance control from the antenna to the load 102.

The LNA 110 may be fabricated as a single chip or IC, e.g. on the same semiconductor substrate. The load 102 may be fabricated on the same IC or coupled through the port 104, e.g., pins or bumps, of a circuit board, cable connector, IC traces, or in any suitable way. In other embodiments, the LNA is fabricated on a separate chip apart from the other components.

A power supply, shown as a power management integrated circuit (PMIC) 112, is coupled to the LNA 110 to provide a supply voltage 144, e.g., Vdd to the components including the first stage 118 and the second stage 108. The IC may also include other components including processors, controllers, modems, clocks, oscillators, and power components, etc. This may allow for better cooling and higher power when the other components are optimized for high speed, lower power, etc. Additional components are not shown in these and the other drawings in order to simplify the diagram such as power supplies, controllers, regulators, input switching, etc.

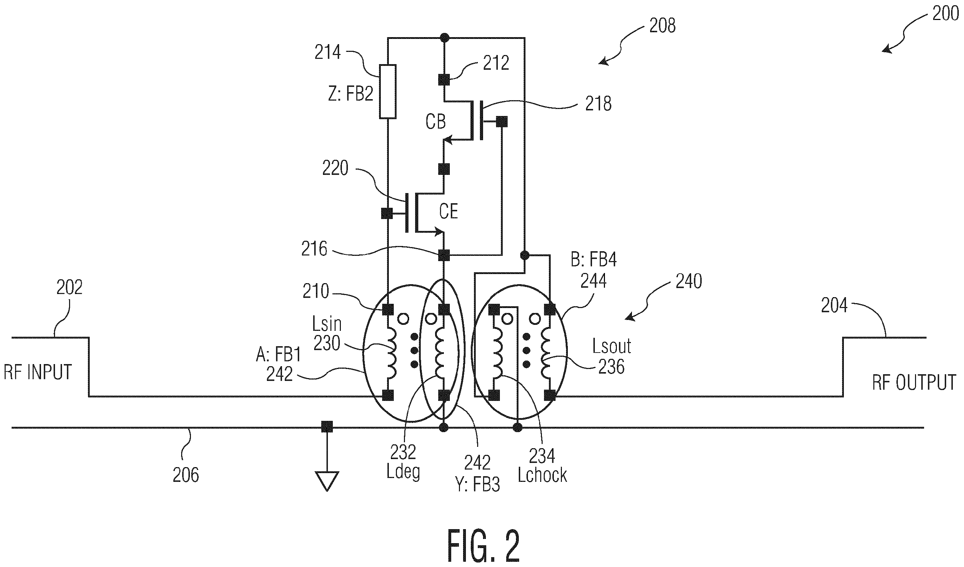

Fig. 2 is a diagram of an LNA 200 with multiple inductors. The LNA 200 is suitable for use as one of the stages of the LNA 110 of Fig. 1, as a single-ended high frequency amplifier. The LNA 200 may be replicated with a mirror image version to form a differential amplifier. The LNA 200 may be replicated to form a two-stage amplifier and a two-stage differential amplifier.

The LNA 200 includes a cascode section 208 and a transformer section 240. While a cascode is shown, any other type of amplifier may be used instead. The input analog signal 202 is a variable voltage RF signal. The input analog signal 202 oscillates with respect to a ground 206 which is a steady 0V signal or some other steady voltage. The output 204 is an amplified version of the input analog signal 202 which oscillates with respect to the same ground 206.

The cascode section 208 has a common base 218 coupled in series to a common emitter 220. While the common base 218 and the common emitter 220 are shown as field effect transistors (FETs), with source and gate, they are referred to as common base and common emitter for simplicity of understanding. While FETs are particularly well -suited to silicon semiconductor fabrication technologies, for other fabrication technologies, other types of transistors may be used including bipolar junction transistors. The gate of the common base 218 and the source of the common emitter 220 are coupled to a ground node 216 that is coupled to ground 206 through a second coil 232.

The drain of the common base 218 is coupled to an output node 212. The gate of the common emitter 220 is coupled to a cascode input node 210 that is also coupled to the output node 212 at the drain of the common base 218. The input node 210 and the output node 212 are coupled together through a resistance between the input node 210 and the output node 212. This resistance is shown as a resistor 214. Alternatively, a resistor capacitor combination may be used, e.g., resistor-capacitor or resistor-capacitor-resistor circuit in a T network, a capacitor-resistor-capacitor circuit in a PI network, or another arrangement. In addition, one side of the third coil 234 and one side of the fourth coil 236 are coupled to the output node 212. The cascode section 208 receives the input analog signal 202 through the first coil 230 and amplifies it through the common emitter 220 to the drain of the common emitter. The common base receives the amplified signal at its source from the drain of the common emitter 220 and generates the output to its drain at the output node 212.

The transformer section 240 has a first coil 242, configured as a shunt coil, that operates as an input inductor for impedance matching and receives the input analog signal 202 at a first end of the first coil 242. A second end of the first coil 242 opposite the first end of the first coil 230 is coupled to the cascode input node 210. The first coil 230 is inductively coupled to a second coil 232 which operates as a degeneration inductor and is connected to the ground node 216 of the cascode at a second end. The first end of the second coil 232 is connected to ground 206. As a degeneration coil, the second coil 232 adds an inductance between the source of the common emitter 320 and ground. This improves the input matching for the input 302, the stability of the output and the linearity of the output. It also reduces noise. The first coil 242 and the second coil 232 are inductively coupled to form a first feedback transformer for a voltage-to-voltage transformer to the input node 210 of the cascode.

A third coil 234 operates as a choke coil and has a first end coupled to the output node 212 of the cascode. The second end of the third coil 234 is connected also to the ground 206. As a choke coil, the third coil 234 filters out low frequency transients and electromagnetic interference from the output 204. A fourth coil 236, configured as a shunt coil, operates as an output impedance matching coil, and is connected at a first end to the output 204 of the amplifier. A second end is coupled to the output node 212. The third coil 234 is inductive coupled to the fourth coil 236 to form a second feedback transformer for a current-to-current transformer to the output node 212.

The configuration of the amplifier for the LNA 200 provides several feedback loops to maintain consistent operation of the LNA 200. A first feedback control is from the first coil 230 which is inductively coupled to the second coil 232. This renders the first coil 230 and the second coil 232 as the first feedback transformer within the transformer section 240. The first feedback transformer provides a voltage-to-voltage transfer from the input analog signal 202 to the cascode input node 210.

A second feedback control is provided by the feedback impedance, e.g., resistor 214, of the cascode section 208. The impedance of this feedback provides current-to-voltage transfer from the input node 210 to the output node 212 of the cascode section 208.

A third feedback control 244 is with the second coil 232. The second coil 232 connects the common emitter 220 drain and the common base 218 gate to ground through the ground node 216. The third feedback control 244 in this way has a transadmittance. It provides a voltage-to-current transfer from the voltage at the ground node 216 to current through the feedback transadmittance.

The fourth feedback control 246 is the second feedback transformer made up of the third coil 234 inductively coupled to the fourth coil 236. This provides a current-to-current transfer to transfer the output current from the output node 212 of the cascode to the output 204 of the LNA 200.

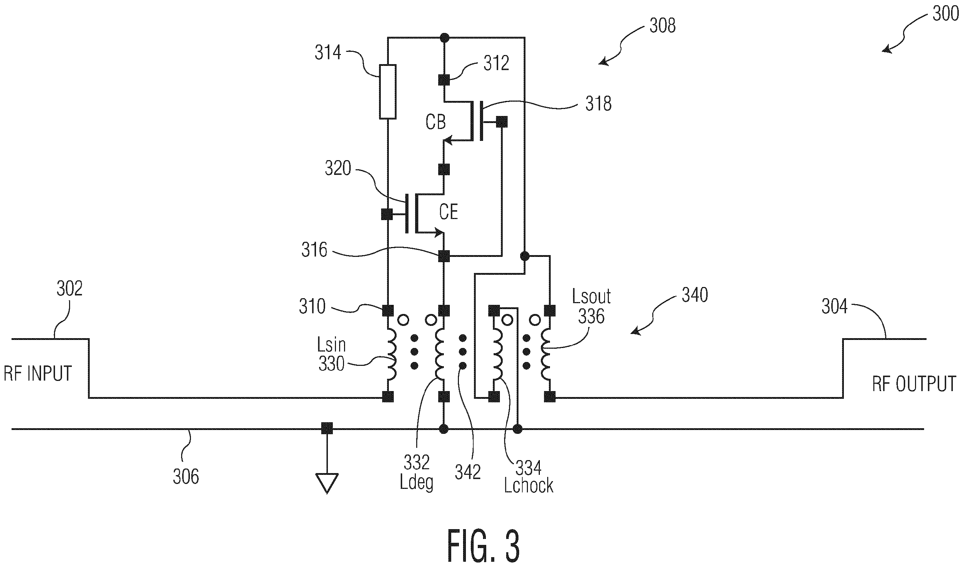

Fig. 3 is a diagram of another LNA 300 with multiple inductors The LNA 300 is similar to the LNA 200 of Fig. 2 with an additional inductive coupling between the second coil 332 and the third coil 334. The LNA 300 is suitable for use as a stage of the LNA 110 of Fig. 1. Modifications and variations may be made to suit different uses. The input 302 is a variable voltage RF signal. The input 302 oscillates with respect to a ground 306 which is a steady 0V signal or some other steady voltage. The output 304 is an amplified version of the input 302 which oscillates with respect to the same ground 306.

The amplifier system of the LNA 300 has a cascode section 308 with a common base 318 coupled in series to a common emitter 320. The gate of the common base 318 and the source of the common emitter 320 are coupled to a ground node 316 that is coupled to ground 306 through a second coil 332. The drain of the common base 318 is coupled to an output node 312. The gate of the common emitter 320 is coupled to a cascode input node 310 that is also coupled to the output node 312 through a resistance, e.g., resistor 314. The cascode section 308 applies the input 302 received at the input node 310 through a first coil 330 and amplifies it through the common emitter 320 to the drain of the common emitter. The common base receives the amplified signal at its source from the drain of the common emitter 320 and generates the output to its drain at the output node 312.

The LNA 300 transformer section 340 has a first coil 330 as an input inductor and receives the input 302 at a first end of the first coil 330. A second end of the first coil 330 opposite the first end of the first coil 330 is coupled to the cascode input node 310. The first coil 330 is inductively coupled to a second coil 332 which operates as a degeneration inductor and is connected to the ground node 316 of the cascode at a second end. The first end of the second coil 332 is connected to ground 306. A third coil 334 operates as a choke coil and has a first end coupled to the output node 312 of the cascode. The second end of the third coil 334 is connected also to the ground 306. A fourth coil 336, is an output coil and is connected at a first end to the output 304 of the amplifier. A second end is coupled to the output node 312. The third coil 334 is inductive coupled to the fourth coil 336. The same feedback loops are present as for the LNA 200 of Fig. 2.

In addition, the second coil 332 is inductively coupled to the third coil 334, as indicated by a coupling symbol 342, due to the relative position and orientation. This inductive coupling adds a positive feedback to the amplifier which improves the gain of the amplifier. The inductive coupling also helps to match the output impedance. In some embodiments, this additional inductive coupling makes the circuit more difficult to design and may reduce the stability of the amplifier operation.

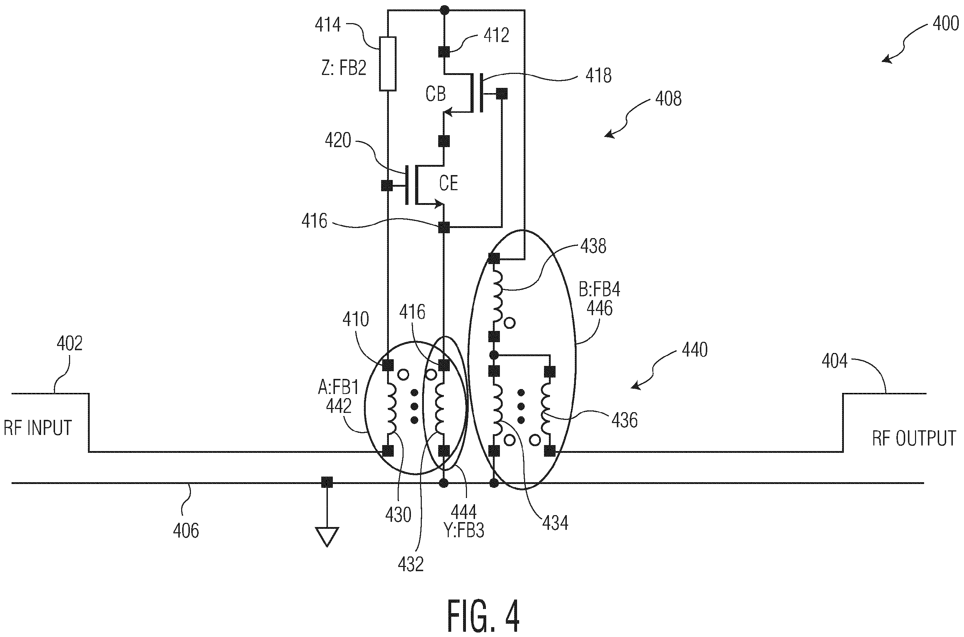

Fig. 4 is a diagram of another LNA 400 with multiple inductors The LNA 400 is similar to the LNA 200 of Fig. 2 with a transformer section 440 having a choke coil divided into two coils, a fifth coil 438 connected in series between a third coil 434 and an output node 412 of a cascode section 408. A fourth coil 436 is coupled as an output coupling coil on one side between the third coil 434 and the fifth coil 438 and on the other side to an output 404 of the LNA 400. The LNA 400 is suitable for use as a stage of the LNA 110 of Fig. 1. Modifications and variations may be made to suit different uses.

Considering the LNA 400 more generally, an input 402 is a variable voltage RF signal, e.g., from an antenna. The output 404 is an amplified version of the input 402 which oscillates with respect to the same ground 406, e.g. to a load.

The LNA 400 has a cascode section 408 with a common base 418 coupled in series to a common emitter 420. The gate of the common base 418 and the source of the common emitter 420 are coupled to a ground node 416 that is coupled to ground 406 through a second coil 432, a degeneration coil. The drain of the common base 418 is coupled to an output node 412. The gate of the common emitter 420 is coupled to a cascode input node 410 that is also coupled to the output node 412 through a resistance, e.g., resistor 414 or other circuit. The cascode section 408 applies the input 402 received at the input node 410 through a first coil 430, an input coil, and amplifies it through the common emitter 420 to the drain of the common emitter. The common base receives the amplified signal at its source from the drain of the common emitter 420 and generates the output to its drain at the output node 412.

The LNA 400 transformer section 440 has the first coil 430 that receives the input 402 at a first end of the first coil 430. A second end of the first coil 430 opposite the first end of the first coil 430 is coupled to the cascode input node 410 at one end ant to ground at the other end. The first coil 430 is inductively coupled to the second coil 432. The choke coil is in two parts with the third coil 434 and the fifth coil 438. The second end of the third coil 434 is connected also to the ground 406. The fourth coil 436, is an output coil and is connected at a first end to the output 404 of the amplifier. A second end is coupled to the output node 412. The third coil 434 is inductive coupled to the fourth coil 436. The same feedback loops 442, 444, 446 are present as for the LNA 200 of Fig. 2.

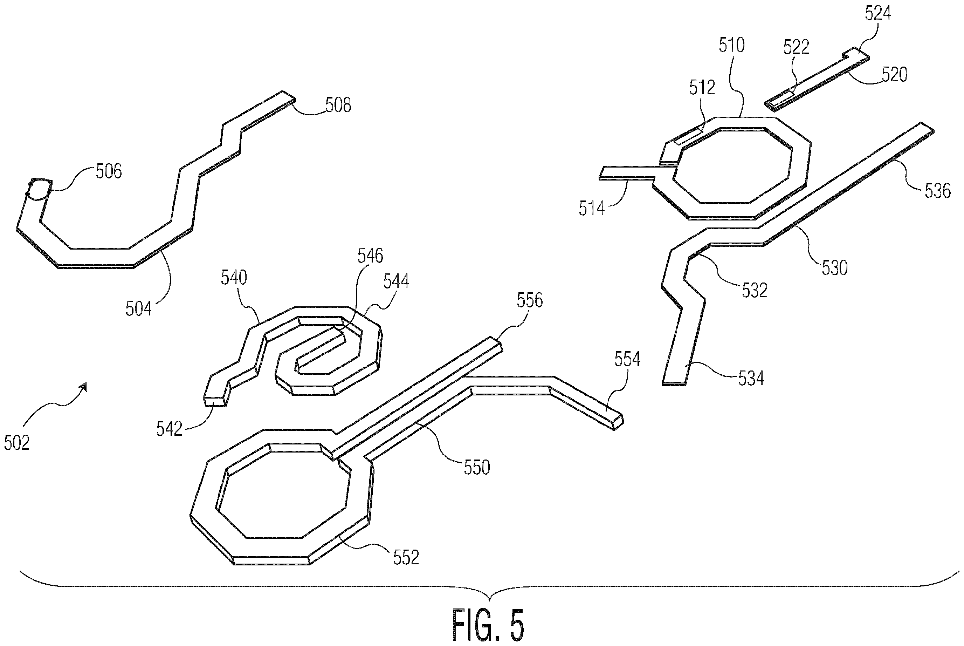

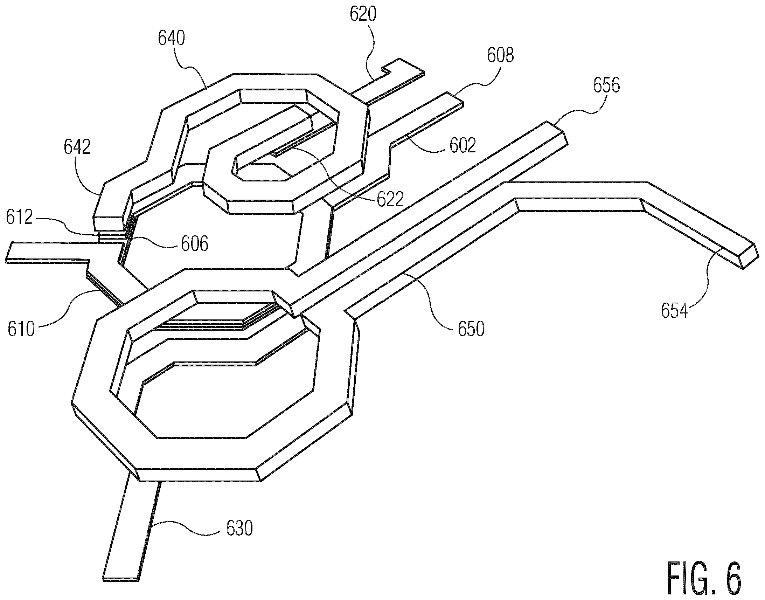

Fig. 5 is an isometric view diagram of three different layers for coils of a transformer section. The four coils are suitable for use with the transformer sections of Fig. 4 and also Figs. 2 and 3. The coils are shown separately for each layer. The layers may be formed as copper, aluminum, or other conductive patterns on an integrated circuit substrate of e.g. silicon, glass, lithium niobate, or a printed circuit board material. In this way, the coils may be formed on the same substrate as the cascodes as part of the same integrated circuit. In a final assembly, the layers are formed over each other, and the coils are electrically connected with connection pads or inductively coupled based on their position. The relative positions of the layers are shown in Fig. 6. A first coil 550 in a top layer corresponds to the first coil 242, the input coil, of the transformer section 240 of Fig. 2. The first coil 550 has a full loop section 552 to receive the input analog signal 202 from an input stub 554 and to provide an inductance to the transformer section input. The full loop section 552 is connected to an output stub 556 to connect to the cascode input node 210 of the cascode section 208.

A second coil 530 in a middle layer corresponds to the second coil 232 of the transformer section 240 of Fig. 2. It has a half loop section 532 coupled to an input stub 536. The input stub is coupled to the ground node 216 of the cascode section 208. An output stub 534 at the opposite side of the half loop section 532 is coupled to ground 206.

A third coil 510 also in the middle layer corresponds to the third coil 234 of the transformer section 240 of Fig. 2. It has a full loop section 516 coupled to an input stub 514 at an input end of the full loop section 516. An output connection pad 512 at an output end of the full loop section 516 opposite the input stub 514 allows for an electrical connection to a fourth coil 540.

The fourth coil 540 also in the top layer corresponds to the fourth coil 236 of the transformer section 240 of Fig. 2. The fourth coil has an input connection pad 542 at an end of an input stub. The input connection pad 542 provides for an electrical connection to the output connection pad 512 of the third coil 510. The input connection pad 542 is coupled to a full and one-half loop section 544. At an opposite side of the one and a half loop section 544 there is an output stub with an output connection pad 546. The output connection pad 546 is configured to connect to an amplifier output by electrically connecting to an output line 520. The output line has an input connection pad 522 at one end to connect to the output connection pad 546 of the fourth coil 540 and a stub 524 at the opposite end of the output line 520 to connect to the amplifier output. The fourth coil 540 is partially over the third coil 510 to inductively couple to the third coil 510.

An optional fifth coil 502 in a bottom layer has an input connection pad 506 to electrically connect to the input connection pad 542 of the fourth coil and the output connection pad 512 of the third coil 510. The input connection pad 506 is coupled to a three-quarter loop 504 at one end of the three-quarter loop 504. An output stub 508 is attached to the opposite end of the three-quarter loop. In this way, the fifth coil 502 is electrically connected to the third coil 510 and to the fourth coil 540. It is also inductively coupled to the third coil 510.

Fig. 6 is an isometric view diagram of the coils of Fig. 5 formed over each other for use as a transformer section of an amplifier such as the amplifiers of Fig. 2 and Fig. 3. The lowest level has the fifth coil 602 with its three-quarter loop section and connection pad 606 at one end that is coupled to the third coil 610. An output stub 608 at the opposite side of the three-quarter loop section of the fifth coil 602 is configured to be coupled to the cascode output.

The third coil 610 is formed on a layer over the fifth coil 602. The third coil 610 has a full loop section that is aligned with the three-quarter loop section of the fifth coil 602 to inductively couple the coils to each other. The turns ratio of the third coil to the fifth coil provides a selected gain for the intended frequencies. The other coil turns ratios for coupling may also be designed to optimize the operation of the LNA. The third coil has a connection pad 612 that is aligned with and electrically connected to the connection pad of the fifth coil 602. The second coil 630 is also formed in the second layer but is not directly aligned with any of the other coils. The output line 620 is formed in the second layer and has a connection pad 622 aligned with and electrically connected to a fourth coil 640, the output coil.

A top layer has the fourth coil 640 aligned with the third coil 610 with a connection pad 642 and a portion of its loop aligned with the loop of the third coil 610. The top layer also has the first coil 650 over the second coil 630. This allows some inductive coupling between these two coils. The first coil 650 has an input stub 654 on one side of its loop and an output stub 656 on the other side of its loop.

The arrangement both vertically and horizontally of the coils in the three layers controls the inductive coupling between the coils as well as the inductance of each coil. The three layers allow the coils to be formed in a compact area. In this example, the first coil 650 and the second coil 630 are formed over each other in a first area. The third coil 610 and the fourth coil 640 are formed over each other in another adjacent area. The second coil 630 and the third coil 610 are formed adjacent to each other horizontally allowing for coupling between the two. Alternatively, these may be isolated to suit particular implementations.

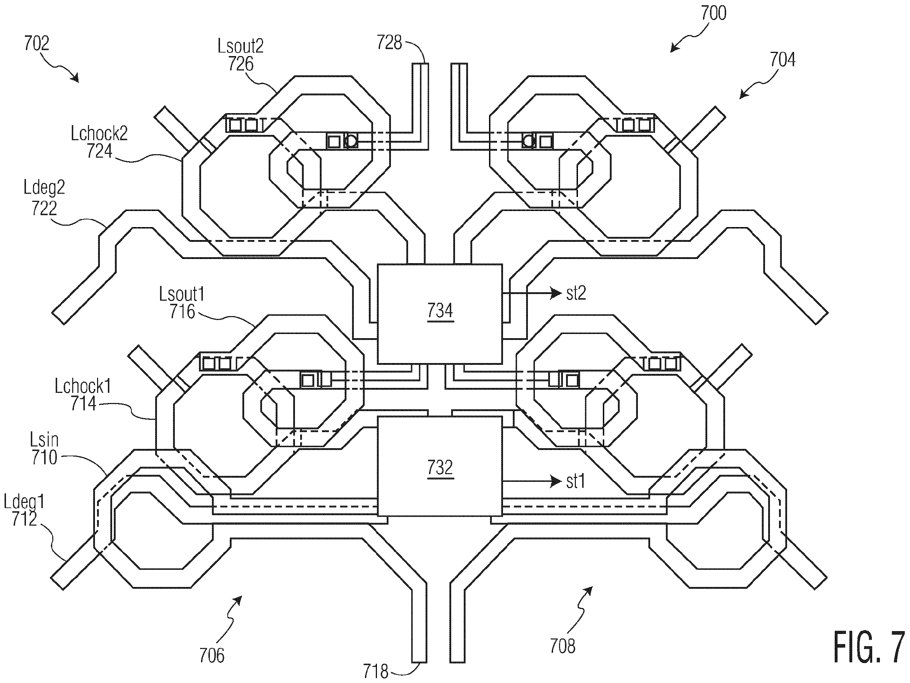

Fig. 7 is a diagram of a two-stage differential amplifier 700. There is a negative two-stage amplifier section, with a negative first stage and a negative second stage, and a positive two-stage amplifier section, with a positive first stage and a positive second stage. The two-stage differential amplifier 700 has four cascode sections: two first stage cascode sections 732 and two second stage cascode sections 734. There is a two-stage negative transformer section with a negative first stage transformer section 706 with a negative input 718 and a negative second stage transformer section 702 with a negative output 728. A two-stage positive transformer section has a mirror image of the same structure as the two-stage negative transformer section. There is a positive first stage transformer section 708 and a positive second stage transformer section 704.

Considering the negative two-stage amplifier section. An input coil 710 receives the negative side of the input signal and couples it to a negative side of the first stage cascode section 732. A degeneration coil 712 couples a ground node of the negative side of the first stage cascode section 732 to ground. A choke coil 714 connects an output node of the negative side of the first stage cascode section 732 to an output coil 716. The output coil 716 of the first stage is coupled to an input of the negative side of the second stage cascode section 734.

At the second stage of the two-stage differential amplifier 700. A degeneration coil 722 couples a ground node of the negative side of the second stage cascode section 734 to ground. A choke coil 724 connects an output node of the negative e side of the second stage cascode section 734 to an output coil 726. The output coil 726 connects to the negative output 728 of the negative side of the two-stage differential amplifier 700. The second stage 704 is between the fourth coil 716 of the first stage 702 and the amplifier output 728. The second stage 702 has an input node, a ground node, and an output node coupled to the amplifier output.

The configuration of the coils of Fig. 7 is the same as or similar to that of Figs 5 and Fig. 6 but are duplicated to form differential sections and multiple stages. In this way, additional stages may be formed using the multiple layers and the coil configurations as described herein. A single ended amplifier with two or more stages may be formed using just the negative side or positive side as shown in Fig. 7. The specific layout and configuration of the coils may be adapted to provide more or less inductance and to provide more or less inductive coupling to other coils. Modifications may also be made to suit different conductive materials for the coils and different dielectric substrates to carry the conductive layers.

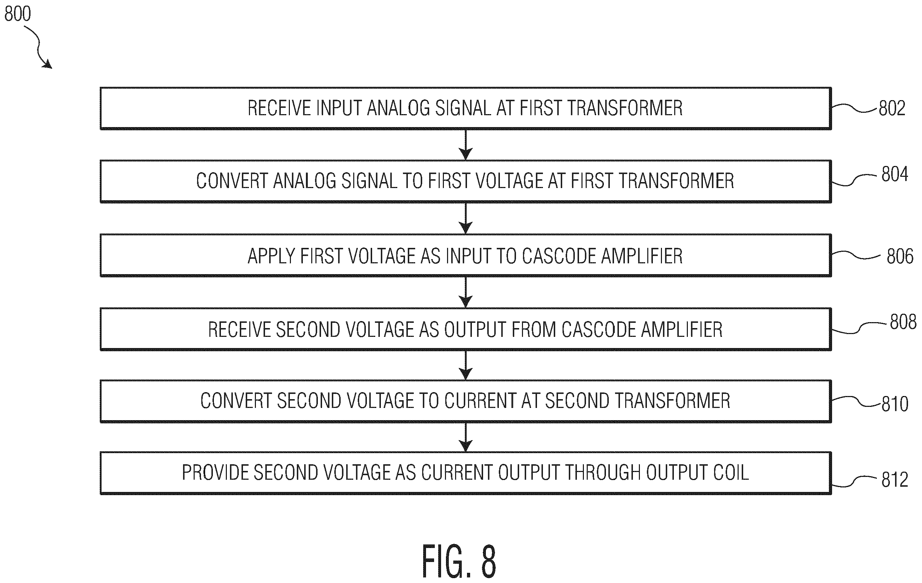

Fig. 8 is a process flow diagram of operating an amplifier system as described above. The process may be adapted to suit additional stages and differential or single-ended configurations. At 802, an input analog signal is received at a first feedback transformer. At 804, the input analog signal, received at the first feedback transformer, is converted to a first voltage at the first feedback transformer. The input analog signal is converted in some examples by applying the input analog signal to a first feedback transformer. The first feedback transformer has an input coil electrically coupled to the input analog signal and a degeneration coil inductively coupled to the input coil and electrically coupled to a ground node of the cascode amplifier.

At 806, the first voltage is applied as an input to a cascode amplifier. At 808, a second voltage is received as an output from the cascode amplifier. At 810, the received second voltage is converted to a current at a second feedback transformer. Converting the second voltage may be done by applying the second voltage to a second feedback transformer. The second feedback transformer has an output coil electrically connected to the second voltage and a choke coil inductively coupled to the output coil.

At 812, the second voltage is provided as a current output to an amplifier through an output coil.

In the present description electrically coupled is used to refer to a direct or indirect connection between two components that uses electrical conductors, e.g., traces, metal lines, wires, etc. Inductively coupled is used to refer to a connection made through an electromagnetic field interaction across a distance as between two coils that are adjacent but not in physical contact.

Although the operations of the method(s) herein are shown and described in a particular order, the order of the operations of each method may be altered so that certain operations may be performed in an inverse order or so that certain operations may be performed, at least in part, concurrently with other operations. In another embodiment, instructions or sub-operations of distinct operations may be implemented in an intermittent and/or alternating manner.

It should also be noted that at least some of the operations for the methods described herein may be implemented using software instructions stored on a computer useable storage medium for execution by a computer. As an example, an embodiment of a computer program product includes a computer useable storage medium to store a computer readable program.

Alternatively, embodiments of the invention may be implemented entirely in hardware or in an implementation containing both hardware and software elements. In embodiments which use software, the software may include but is not limited to firmware, resident software, microcode, etc.
Although specific embodiments of the invention have been described and illustrated, the invention is not to be limited to the specific forms or arrangements of parts so described and illustrated. The scope of the invention is to be defined by the claims appended hereto and their equivalents.

## Claims

1. An amplifier system comprising:
a first coil electrically coupled to an input node of an amplifier, configured to provide an input to the input node;
a second coil inductively coupled to the first coil and electrically coupled to a ground node of the amplifier, configured to ground the amplifier;
a third coil electrically coupled to an output node of the amplifier and to ground, configured to filter an amplifier output at the node; and
a fourth coil inductively coupled to the third coil and electrically coupled to the output node, configured to provide the amplifier output.

2. The amplifier system of claim 1, wherein the amplifier is a cascode.

3. The amplifier system of claim 2, wherein the ground node is coupled to a gate of a common base of the cascode and to a source of a common emitter of the cascode.

4. The amplifier system of claim 2, further comprising a resistance between the input node of the cascode and a drain of a common base of the cascode.

5. The amplifier system of claim 4, wherein the resistance comprises a resistor capacitor combination.

6. The amplifier system of any of claims 1 to 5, wherein the first coil, the second coil, the third coil, and the fourth coil are formed as conductive layers on a substrate of an integrated circuit.

7. The amplifier system of claim 6, wherein the first coil and the second coil are formed on different layers on the substrate.

8. The amplifier system of claim 6 or 7, wherein the third coil is in a first layer having a first connection pad, wherein the fourth coil is a second layer having a second connection pad, wherein the first connection pad is electrically coupled to the second connection pad, and the fourth coil is inductively coupled to the third coil.

9. The amplifier system of any of claims 1 to 8, wherein the first coil and the second coil are configured as a first feedback transformer for a voltage-to-voltage transformer to the input node.

10. The amplifier system of any of claims 1 to 9, wherein the third coil and the fourth coil are configured as a second feedback transformer for a current-to-current transformer to the output node.

11. The amplifier of any of claims 1 to 10, wherein the first coil and the fourth coil are shunt coils.

12. The amplifier of any of claims 1 to 11, wherein the second coil is a degeneration coil.

13. The amplifier of any of claims 1 to 12 wherein the third coil is a choke coil.

14. The amplifier of claim 13, wherein the choke coil further comprises a fifth coil coupled in series with the third coil, wherein the fifth coil is coupled to an output of the amplifier on one side and to the third coil on the other side, wherein the third coil is coupled to the fifth coil on one side and to the ground on the other side, and wherein the fourth coil is coupled to the junction of the third coil and the fifth coil.

15. A method comprising:
receiving an input analog signal at a first feedback transformer;
converting the input analog signal to a first voltage at the first feedback transformer;
applying the first voltage as an input to a cascode amplifier;
receiving a second voltage as an output from the cascode amplifier;
converting the second voltage to a current at a second feedback transformer; and
providing the second voltage as a current output to an amplifier through an output coil.
